# EUROPEAN PATENT APPLICATION

(11) **EP 2 151 670 A1**
(43) Date of publication of application: **10.02.2010**
(21) Application number: 08013944.7
(22) Date of filing: 04.08.2008
(51) Int. Cl.: G01D 3/08, G01R 31/01, G01R 31/28

(54) **Potentiometer status safety reading**

(71) Applicant: Rockwell Automation Germany GmbH & Co. KG, 42329 Wuppertal (DE)
(72) Inventor: Lorenz, Dirk, 58300 Wetter (DE)
(74) Representative: Grünecker, Kinkeldey, Stockmair & Schwanhäusser Anwaltssozietät

(57) **Abstract**

A method, device and circuits are provided for determining the status of a potentiometer. The potentiometer has a sliding terminal and a first and second fixed terminal. A first and second resistor are connected to the first and second fixed terminal and a reference potential. A predetermined potential is connected to the sliding terminal. Voltage drops across the first and the second resistor provide a measure for the status of the potentiometer. The first or the second voltage drop or both are utilized as a control signal associated with the status of the potentiometer. Both voltage drops are utilized for detecting a failure of the potentiometer. Sources of failure at the potentiometer and potentiometer connections level are recognized and identified.

## Description

### Background of the Invention

### Field of the Invention

The invention relates to a method, a device and circuits for determining the status of a potentiometer. In particular, the present invention relates to a method, device and circuits providing safety reading of settings of a control device employing a potentiometer for generating a control signal while reliably detecting a failure of the potentiometer.

### Description of the Related Art

In safety control devices, it is often advisable to configure the devices with potentiometer or BCD rotary switches. An example for a conventional potentiometer is a three terminal resistor where the position of the sliding connection is continuously adjustable. Such potentiometers are often employed in safety devices for generating a control input for electronic circuits.

In safety applications, it is further mandatory to ensure that a failure at the potentiometer level is immediately recognized and that the safety function provided by the safety application is not avoided or negated.

Conventional solutions in the area of safety applications for this purpose employ two switch circuits that have to be adjusted in an identical manner. In this configuration, a microcontroller unit (MCU) reads the settings of both switches and compares the results for validation and failure recognition. Redundancy is a conventional concept in safety features and equipment but always involves the disadvantages of additional costs, additional required space, and impairment of mechanical stability. It is thus advantageous to not introduce more redundancy as absolutely necessary.

### Summary of the Invention

It is the object of the present invention to provide an improved method and devices for reliably determining the status of a potentiometer.

This object is solved by the subject matter of the independent claims.

Preferred embodiments are defined in the dependent claims.

A method is provided for determining the status of a potentiometer having a sliding terminal and a first and a second fixed terminal. The method comprises the steps of applying a predetermined potential to the sliding terminal, connecting a first and a second resistor to the first and the second fixed terminal, respectively, thereby connecting respective partial resistances of the potentiometer in series to the first and the second resistor, connecting the first and the second resistor to a reference potential, and picking off a first and a second voltage at the connection between the first fixed terminal and the first resistor and the second fixed terminal and the second resistor, respectively. At least one of the first and the second voltages is utilized as a control signal associated with the status of the potentiometer, and the first and the second voltage are both utilized for detecting a failure of the potentiometer.

According to an aspect of the present invention, a circuit is provided which allows to determine the status of a potentiometer for safety applications. The circuit comprises a potentiometer having a sliding terminal and a first and a second fixed terminal. The device further comprises a first and a second resistor respectively connected to the first and the second fixed terminal and connected to a reference potential. The sliding terminal is connected to a predetermined potential and the voltage drops across the first and the second resistor provide a measure for the status of the potentiometer.

According to yet another aspect of the present invention, the above circuit is included in a switch having switch settings, wherein the sliding terminal is configured in accordance with a setting of the switch, thereby setting a partial and the corresponding complementary partial resistance of the potentiometer. The switch may have discrete or continuous switch settings.

According to yet another aspect of the present invention, an evaluating circuit for determining the status of a potentiometer is provided. The evaluating circuit comprises a first and a second voltage input terminal. The evaluating circuit further comprises evaluating means adapted for evaluating a first and a second voltage applied via the voltage input terminals and respectively associated with a resistance fraction of a first and a second resistor connected in series with respective partial resistances of a potentiometer, comprising utilizing at least one of the first and the second voltages as a control signal associated with the status of the potentiometer, and utilizing both the first and the second voltage for detecting a failure of the potentiometer.

According to yet another aspect of the present invention, a potentiometer device is provided comprising a potentiometer, two resistors and four device terminals. The potentiometer has an adjustable tap terminal and two fixed terminals. A first device terminal is connected to the two resistors, which are connected to respective fixed terminals of the potentiometer. A second device terminal is connected to the adjustable tap terminal of the potentiometer. A third and the fourth device terminal are each respectively connected between a fixed terminal and the corresponding resistor.

The present invention is based on the notion that the introduction of component redundancy is detrimental to stability and miniaturization of control devices for safety applications. The present invention is further based on the notion that the employment of reference resistors in a method and device for determining the status of a potentiometer is advantageous compared to configurations where partial voltages are directly picked off from the terminals of the potentiometer, thereby reducing the dependency on the specifications, quality and stability of the potentiometer components.

It is an advantage of the present invention to reduce switch component redundancy. It is a further advantage of the present invention to provide for reliable detection of a failure of the potentiometer, including open pins and short circuits among connections at the three terminals of the potentiometer, wherein the failure recognition and identification is independent of the resistance values used for the potentiometer and the reference components, including a first and a second ohmic resistor. Still, the present invention allows to recognize a change of resistor values by comparison with predefined valid values associated with the normal resistance values of the components. It is a further advantage of the present invention to generate a control signal according to the status of the potentiometer and at the same time allow to detect a failure with one and the same configuration. Specifically, the control signal is generated based on at least one of the two voltages which are used for the failure detection and evaluation. Further, according to the present invention, no voltage switching at the input terminals is required, thus avoiding time delays in the failure detection.

### Brief Description of the Drawings

The above and other aspects, features, and advantages of the embodiments of the present invention will become more apparent from the following detailed description when taken in conjunction with the accompanying drawings in which:
Fig. 1 is a schematic illustrating a device according to an embodiment of the present invention;
Fig. 2 is a flow chart illustrating a method for determining the status of a potentiometer according to an embodiment of the present invention; and
Fig. 3 illustrates a diagram showing voltage drops according to embodiments of the present invention for determining the status of a potentiometer.

### Detailed Description of Exemplary Embodiments

Exemplary embodiments of the present invention will now be described in detail with reference to the annexed drawings.

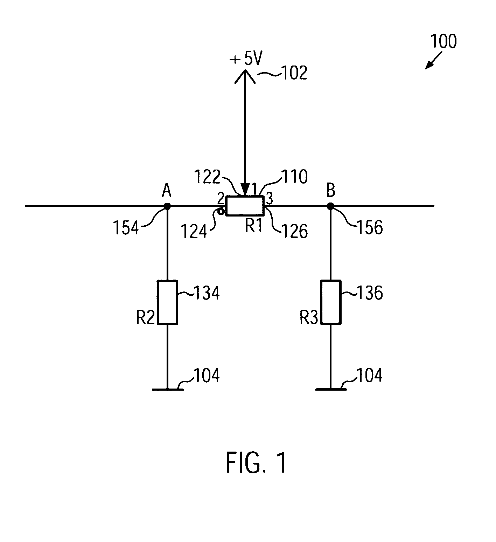

Fig. 1 is a schematic illustrating an exemplary device for determining the status of a potentiometer 110 according to an embodiment of the present invention. The potentiometer has a sliding terminal 122, a first fixed terminal 124 and a second fixed terminal 126. Accordingly, potentiometer 110 is a three terminal resistor where the position of the sliding connection is adjustable. Potentiometer 110 may be employed in a switch as a control input for electronic circuits. The switch may have a continuous range of switch settings, wherein the sliding connection of the potentiometer is continuously adjusted, or discrete switch settings, wherein the sliding terminal of the potentiometer is set to discrete positions, thereby defining a partial resistance between pins 1 and 2 and a complementary partial resistance between pins 1 and 3. A first ohmic resistor 134 (R2) is connected in series with the first fixed terminal 124, thereby being connected in series with the partial resistance defined by the position of the sliding terminal 122, the total resistance value of the potentiometer and the potentiometer characteristics. The potentiometer may be of the linear taper type. However, other types of potentiometers may be utilized according to the present invention. A second ohmic resistor 136 (R3) is connected in series to the second fixed terminal 126, thereby being connected in series with the partial resistance which is complementary to the above partial resistance, the two complementary resistances combined corresponding to the total resistance value of the potentiometer.

A predetermined potential 102 is connected to the sliding terminal 122 and a reference potential 104 is connected to both the first ohmic resistor 134 and the second ohmic resistor 136 on the side opposite to the connection of the resistors to the potentiometer.

Accordingly, a voltage corresponding to the difference of the predetermined potential and the reference potential is applied to the two series connections of the complementary resistances of the potentiometer, according to the configuration of the sliding terminal 122, with the first and the second ohmic resistor, 134 and 136, respectively. In an embodiment, the predetermined potential corresponds to the operating voltage of a control device including a switch employing the potentiometer. The reference potential preferably may be ground.

In the example illustrated in Fig. 1, the predetermined potential is set to +5V and the reference potential is set to ground. Accordingly, a total voltage of 5V is applied to both series connections. A voltage drop A picked off or measured at point A at the connection 154 between the first ohmic resistor 134 and the first fixed terminal 124 of the potentiometer 110 accordingly provides the partial voltage applied to the first resistor 134. Similarly, a voltage drop B picked off at a connection 156 between the second ohmic resistor 136 and the second fixed terminal 126 of the potentiometer 110 provides the partial voltage applied to the second resistor 136. The picked off voltage drops A and B correspond to the resistance value fraction of the respective ohmic resistor to the total resistance in the respective series connection of ohmic resistor and partial potentiometer resistance.

A microcontroller unit (MCU) may be utilized to read the analog voltage drop values A and B picked off at the connections 154 and 156. With the exemplary configuration illustrated in Fig. 1, it is possible to determine the status of the potentiometer, including the setting of the partial resistances of the potentiometer, and it is possible to detect all failures of the potentiometer including shorts and open terminal connections. If the potentiometer is working as intended, the voltages A and B have to fulfill certain predetermined conditions. In particular, for each setting of the potentiometer comprising configuring the sliding terminal 122, a range of valid values for each setting of the potentiometer may be defined in accordance with the parameters of the potentiometer, the first and the second ohmic resistor and the connecting components, and in accordance with the quality parameters of all components.

As exemplarily illustrated in Fig. 1, 5V may be applied to the sliding terminal 122 and the first and the second resistor may be connected to ground. Further, given that the total resistance value of the potentiometer 110 is 10kΩ and that both the first and the second ohmic resistor have a resistance value of 4.7kΩ, exemplary valid values for each of ten exemplary switch settings applicable to the potentiometer 110 are defined as shown in table 1 below specifically illustrating valid values for voltages A and B versus the exemplary switch settings.

**Table 1**

| **Switch setting** | **R_{left} / Ω** | **R_{right} / Ω** | **Vollage A / V** | **Voltage B / V** | **R2 / Ω** | **R3 / Ω** |
|---|---|---|---|---|---|---|
| 1 | 0 | 10000 | 5.00 | 1.59 | 4700 | 4700 |
| 2 | 1120 | 8940 | 4.04 | 1.72 | | |
| 3 | 2240 | 7830 | 3.39 | 1.88 | | |
| 4 | 3360 | 6710 | 2.92 | 2.06 | | |
| 5 | 4470 | 5600 | 2.56 | 2.28 | | |
| 6 | 5590 | 4490 | 2.28 | 2.56 | | |
| 7 | 6700 | 3380 | 2.06 | 2.91 | | |
| 8 | 7840 | 2230 | 1.87 | 3.39 | | |
| 9 | 8950 | 1120 | 1.72 | 4.04 | | |
| 10 | 10000 | 0 | 1.59 | 5.00 | | |

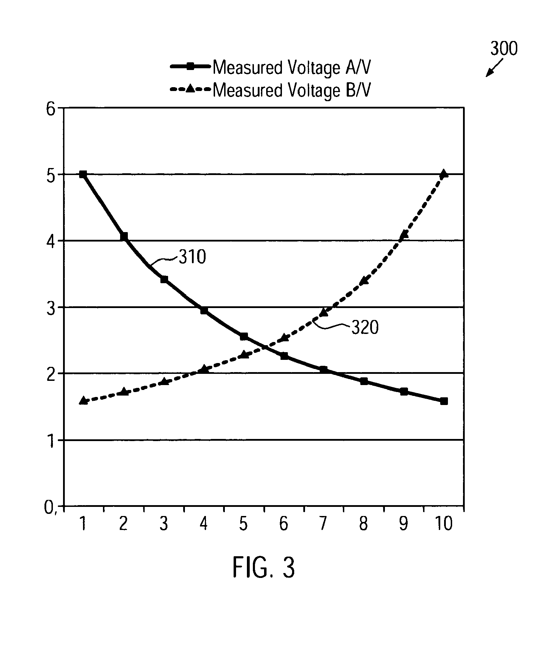

Voltages A and B picked off at connections 154 and 156, respectively, are also shown in Fig. 3 illustrating the functional dependency of the voltage drops across the first and the second resistor, respectively, from the switch setting applied to the potentiometer 110. As depicted in Fig. 3 and according to an embodiment of the present invention, voltages A and B shall be not equal for each of the switch settings, including the provision that also the defined ranges for the switch settings do not overlap for the switch settings. The present invention allows for defining the partial resistances according to the switch settings in combination with the resistance values of the first and the second resistor such that this condition may be fulfilled for discrete switch settings.

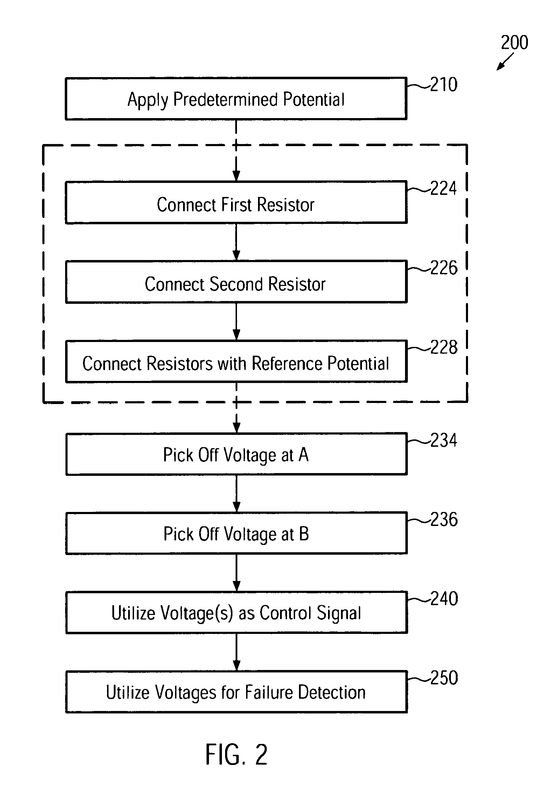

With further reference to Fig. 2 showing a flow chart illustrating a method for determining the status of a potentiometer according to an embodiment of the present invention, the following steps are performed. It will be understood that the sequence of steps shown in Fig. 2 is of illustrative nature and not of restrictive nature. Accordingly, connecting steps 224, 226 and 228 may be performed before the other steps of the method or be provided in a permanent manner as indicated by the dashed line around steps 224, 226 and 228.

The method comprises the steps of applying, step 210, a predetermined potential 102 to the sliding terminal 122 of potentiometer 110. A first ohmic resistor 134 is connected, step 224, to the first fixed terminal 124 of the potentiometer 110 and a second ohmic resistor 136 is connected, step 226, to the second fixed terminal 126 of potentiometer 110. Both ohmic resistors are connected, step 228, to a reference potential 104. In step 234, a voltage A is picked off at a connection 154 between the first ohmic resistor 134 and the first fixed terminal 124. In step 236, a voltage B is picked off at a connection 156 between the second ohmic resistor 136 and the second fixed terminal 126.

The method comprises further to utilize voltage A or voltage B or both voltages as a control signal associated with the status of the potentiometer, step 240. This may comprise to generate a safety control signal corresponding to the status of the potentiometer. The status of the potentiometer may relate to the configuration of the sliding terminal. In an embodiment, this includes configuring the sliding terminal in accordance with the setting of a switch comprising the potentiometer. As can be seen, for example, from the diagram illustrated in Fig. 3, it is sufficient in accordance with an embodiment of the present invention to utilize only one of the voltages A and B for determining the status of the potentiometer, e.g. for determining a discrete switch setting. It may, however, be advantageous to evaluate both voltages A and B. As can be seen from the diagram shown in Fig. 3, the functional dependency of the measured voltages from the switch settings is not linear, thereby diminishing the differences between voltages at switch settings 1 to 5 for voltage B 320, and similarly for switch settings 6 to 10 for picked off voltage A 310. According to an embodiment of the present invention, therefore, it is first determined which one of the picked off voltages is larger. That particular voltage is then utilized as the control signal associated with the status of the potentiometer. This allows for the further advantage of added accuracy with respect to the determination of the potentiometer status.

In step 250, the voltages A and B are utilized for detecting a failure of the potentiometer. According to an embodiment, the utilizing the first and the second voltage for detecting a failure of the potentiometer comprises identifying a failure condition from a set of predefined failure conditions. For this purpose, both voltages A and B are compared with predetermined values. These predetermined values are associated with a failure. Table 2 below shows a table with possible failure conditions of the potentiometer, the respective identifications by which a failure may be recognized and identified and the result of a comparison with valid values predetermined for valid statuses of the potentiometer. Table 2 uses the same exemplary configuration as used for the example providing the basis for table 1, including that the same exemplary values for the predetermined potential and the reference potential are used, the resistance values of the first and the second resistor are identical, and that there is no status of the potentiometer where the measured voltages A and B validly should be equal.

**Table 2**

| **failure of potentiometer** | **failure identification** | **comparison with valid values** |
|---|---|---|
| pin 1 open | A and B both 0V | invalid values, not in table |
| pin 2 open | A = 0V | invalid values, not in table |
| pin 3 open | B = 0V | invalid values, not in table |
| short 1 to 2 | A always 5V | invalid values, not in table |
| short 1 to 3 | B always 5V | invalid values, not in table |
| short 2 to 3 | A and B equal | invalid values, not in table |
| short 1 to 2 to 3 | A and B = 5V | invalid values, not in table |
| change of resistances | none of the above | invalid values, not in table |

As can be seen from the first three rows of the table, individually open pins at either one of the terminal connections of the potentiometer may be identified by respectively only one of the voltages A or B or both being 0V. A comparison of the value pair including voltage A and voltage B with a table of valid voltages as shown in table 1 would result in at least one of both voltages being identified as invalid.

Short circuits among pins 1 and 2 or pins 1 and 3 would be identified by either voltage A or voltage B, respectively, being 5V, irrespective of the value of the picked off other voltage. That is, as the value of 5V alone may be a valid value for one of the picked off voltages A or B in this example, the other picked off voltage would have to comply with the corresponding minimum voltage of 1.59 volt to be valid. In an embodiment, the present invention thus comprises a history buffer for an evaluating circuit or a microcontroller unit evaluating the voltages picked off at A and B.

A short circuit among pins 2 and 3 could be detected and identified by voltages A and B being of equal value. As such a configuration is excluded from the valid table of values shown in table 1, this condition allows immediate recognition of a failure and also identification of the failure source being a short circuit among pins 2 and 3. Referring to the second to last row of table 2, a short among all pins of the potentiometer, comprising pins 1, 2 and 3, may be identified in both voltages A and B being equal to 5V.

As can be seen from table 2 and the above discussion of the rows of table 2 referring to the specific failure conditions, the present invention allows the recognition and identification of sources of a failure at the potentiometer level which does not require to consider or evaluate the parameters of the resistor components used in the circuit. The conditions of one or both of the picked off voltages being 5V or 0V or both voltages being identical to each other may be recognized independently of the resistance values of the employed ohmic resistors or the values of the partial resistances of the potentiometer reflecting the set state of the potentiometer.

With further reference to the last row of table 2, a change of the resistance values in the circuit depicted in Fig. 1 is also identified by means of the present invention, however requires a comparison with the valid values which may, for example, be provided in a table of a memory of the MCU, which preferably may be of nonvolatile type.

According to an embodiment of the present invention, the evaluation of the voltages A and B picked off at the connections 154 and 156 is performed by an evaluating circuit for determining the status of the potentiometer. The circuit comprises a first input terminal for receiving a first voltage. The first voltage is associated with a resistance fraction of the first resistor connected in series with a partial resistance defined by the configuration of the sliding terminal 122 of the potentiometer 110. A second input terminal is provided for receiving a second voltage, which is associated with a resistance fraction of the second resistor connected in series with the complementary partial resistance of the potentiometer 110. The evaluating circuit further comprises evaluating means adapted for evaluating the first and the second voltage. For this purpose, at least the first or the second voltage or both are utilized as a control signal associated with the status of the potentiometer. This utilization preferably comprises generating a safety control signal corresponding to the status of the potentiometer. Both the first and the second voltage are utilized for additionally detecting a failure of the potentiometer.

The present invention allows to detect all failures at the potentiometer and the potentiometer connections level. For this purpose, an evaluation device or circuit may be utilized. In an embodiment, an MCU is employed. To introduce redundancy with respect to the evaluation only, two MCUs may be employed to additionally detect a failure of an individual MCU.

The inventive method, device and circuits for determining the status of a potentiometer allow for further miniaturization and cost savings for safety switches and general control inputs for electronic circuits while enhancing reliability of the generated control signal.

While the present invention has been shown and described with reference to certain exemplary embodiments thereof, it will be understood by those skilled in the art, that various changes in form and detail and combinations may be made therein without departing from the scope of the invention as defined by the appended claims. In addition, those areas in which it is believed that those of ordinary skill in the art are familiar, have not been described herein in order to not unnecessarily obscure the invention described herein. Accordingly, it is to be understood that the invention is not to be limited by the specific illustrative embodiments, but only by the scope of the appended claims.

## Claims

1. A method for determining the status of a potentiometer (110) having a sliding terminal (122) and a first (124) and a second (126) fixed terminal, the method comprising the steps of:
applying (210) a predetermined potential (102) to the sliding terminal;
connecting(224) a first resistor (134) to the first fixed terminal, thereby connecting a partial resistance of the potentiometer in series to the first resistor;
connecting (226) a second resistor (136) to the second fixed terminal, thereby connecting the complementary partial resistance of the potentiometer in series to the second resistor;
connecting (228) the first and the second resistor to a reference potential (104);
picking off (234) a first voltage at the connection (154) between the first fixed terminal and the first resistor;
picking off (236) a second voltage at the connection (156) between the second fixed terminal and the second resistor;
utilizing (240) at least one of the first and the second voltages as a control signal associated with the status of the potentiometer; and
utilizing (250) the first and the second voltage for detecting a failure of the potentiometer.

2. The method according to claim 1, the utilizing the first and the second voltage for detecting a failure comprising
comparing at least one of the first and the second voltage with a corresponding value of a discrete set or a continuous range of predetermined value pairs, each value pair associated with a predetermined valid status of the potentiometer.

3. The method according to claim 2, the utilizing the first and the second voltage for detecting a failure comprising
identifying a failure condition from a set of predefined failure conditions including comparing the first and the second voltage with predetermined values associated with a failure.

4. The method according to one of claims 1 to 3, the utilizing the first and the second voltage for detecting a failure comprising
if only one of the first and the second voltage is determined to be equal to a predetermined value associated with a failure, comparing the other of the first and the second voltage with a corresponding value of predetermined value pairs, each value pair associated with a predetermined valid status of the potentiometer.

5. The method according to claim 3, the set of predefined failure conditions comprising shorts amongst pairs of connections at the potentiometer terminals, a short amongst connections at all three potentiometer terminals, singularly open connections at each of the potentiometer terminals, and a change of resistance values.

6. The method according to claim 5, wherein
an open connection at the first or the second fixed terminal is identified based on only the first or the second voltage, respectively, being zero;
an open connection at the sliding terminal is identified based on both the first and the second voltage being zero;
a short amongst connections at the sliding terminal and the first or the second fixed terminal is identified based on only the first or the second voltage respectively corresponding to the predetermined potential and the second or the first voltage, respectively, not corresponding to the corresponding value of the corresponding value pair;
a short amongst connections at the first and the second fixed terminal is identified by the first and the second voltage being equal;
a short amongst connections at all three potentiometer terminals is identified by both the first and the second voltage corresponding to the predetermined potential; and
a change of resistance values is identified based on at least one of the first and the second voltage not corresponding to any of the values comprised in the set of predetermined value pairs, while none of the other predefined failure conditions is identified.

7. The method according to one of claims 1 to 6, wherein the predetermined potential (102) is the operating voltage of a control device and the reference potential (104) is ground.

8. The method according to one of claims 1 to 7, wherein the first and the second resistor have the same value of resistance.

9. The method according to one of claims 1 to 7, the first and the second resistor having resistances such that for each valid status of the potentiometer and the absence of a failure the first and the second voltage are not equal.

10. The method according to one of claims 1 to 9, the utilizing the at least one of the first and the second voltages as a control signal associated with the status of the potentiometer comprising
generating a safety control signal corresponding to the status of the potentiometer.

11. A circuit (100) comprising a potentiometer (110) having a sliding terminal (122) and a first (124) and a second (126) fixed terminal, the device further comprising:
a first resistor (134) connected to the first fixed terminal and a reference potential; and
a second resistor (136) connected to the second fixed terminal and the reference potential,
wherein the sliding terminal is connected to a predetermined potential and the voltage drops across the first and the second resistor provide a measure for the status of the potentiometer.

12. The circuit according to claim 11, the voltage drops across the first and the second resistor allowing to detect a failure of the potentiometer.

13. The circuit according to claim 11 or 12, wherein the circuit is comprised in a switch having a plurality of discrete switch settings, and the sliding terminal is configured in accordance with a switch setting, thereby setting a partial and a complementary partial resistance of the potentiometer.

14. The circuit according to claim 11 or 12, wherein the circuit is comprised in a switch having a range of continuous switch settings, and the sliding terminal is configured in accordance with a switch setting, thereby setting a partial and a complementary partial resistance of the potentiometer.

15. An evaluating circuit for determining the status of a potentiometer, the evaluating circuit comprising:
a first voltage input terminal;
a second voltage input terminal; and
evaluating means adapted for evaluating a first voltage received via the first voltage input terminal, which first voltage is associated with a resistance fraction of a first resistor connected in series with a partial resistance of a potentiometer, and a second voltage received via the second voltage input terminal, which second voltage is associated with a resistance fraction of a second resistor connected in series with the complementary partial resistance of the potentiometer, the evaluating comprising utilizing at least one of the first and the second voltages as a control signal associated with the status of the potentiometer; and utilizing the first and the second voltage for detecting a failure of the potentiometer.

16. The evaluating circuit according to claim 15, further comprising means specifically adapted for performing the method of one of claims 2 to 6 and 10.

17. A potentiometer device comprising a potentiometer (110) having a sliding terminal (122) and a first (124) and a second (126) fixed terminal, the device further comprising
four device terminals;
a first resistor (134) connected to the first fixed terminal of the potentiometer and a first of said device terminals; and
a second resistor (136) connected to the second fixed terminal of the potentiometer and said first device terminal,
wherein a second of said device terminals is connected to the sliding terminal of the potentiometer, a third of said device terminals is connected between the first fixed terminal and the first resistor, and the fourth of said device terminals is connected between the second fixed terminal and the second resistor.

18. The potentiometer device according to claim 17, wherein said first device terminal is adapted for connecting a reference voltage, said second device terminal is adapted for applying an operating voltage, and said third and fourth device terminals are adapted for picking off voltage drops across the first and the second resistor to provide a measure for the status of the potentiometer.
